# FASCICULE DE BREVET EUROPEEN

(11) **EP 3 316 319 B1**
(45) Date de publication et mention de la délivrance du brevet: **04.12.2019**
(21) Numéro de dépôt: 17199064.1
(22) Date de dépôt: 28.10.2017
(51) Int. Cl.: H01L 31/068, H01L 31/18

(54) **CELLULES PHOTOVOLTAÏQUES A CONTACTS ARRIERE ET LEUR PROCEDE DE FABRICATION**
FOTOVOLTAIKZELLEN MIT RÜCKSEITIGEN KONTAKTEN UND HERSTELLUNGSVERFAHREN DAVON
PHOTOVOLTAIC CELLS WITH REAR CONTACTS AND THEIR METHOD FOR MANUFACTURING

(30) Priorité: 28.10.2016 FR 1660525
(43) Date de publication de la demande: 02.05.2018
(73) Titulaire: Commissariat à l'Energie Atomique et aux Energies Alternatives, 75015 Paris (FR)
(72) Inventeur: Cabal, Raphaël, 73000 Chambéry (FR)
(74) Mandataire: GIE Innovation Competence Group

(56) Documents cités:
- WO-A1-2012/074602
- US-A1- 2007 151 598
- US-A1- 2011 214 719
- TANVIR NAUMAN BIN ET AL: "Codiffusion Sources and Barriers for the Assembly of Back-Contact Back-Junction Solar Cells", IEEE JOURNAL OF PHOTOVOLTAICS, I E E E, US, vol. 5, no. 6, 1 novembre 2015 (2015-11-01), pages 1813-1820, XP011588074, ISSN: 2156-3381, DOI: 10.1109/JPHOTOV.2015.2478073 [extrait le 2015-10-19]
- ENGELHARDT JOSH ET AL: "Passivating boron silicate glasses for co-diffused high-efficiency n-type silicon solar cell application", APPLIED PHYSICS LETTERS, A I P PUBLISHING LLC, US, vol. 107, no. 4, 27 juillet 2015 (2015-07-27), XP012199334, ISSN: 0003-6951, DOI: 10.1063/1.4927667 [extrait le 1901-01-01]
- PROCEEDINGS OF THE 29TH EUROPEAN PHOTOVOLTAIC SOLAR ENERGY CONFERENCE AND EXHIBITION, WIP-RENEWABLE ENERGIES, SYLVENSTEINSTR. 2 81369 MUNICH, GERMANY, 3 novembre 2014 (2014-11-03), XP040677555, ISBN: 978-3-936338-34-8

## Description

### Domaine technique

L'invention se rapporte au domaine technique des cellules photovoltaïques à contacts arrière, pouvant être de type IBC (« *Interdigitated Back Contact* » en langue anglaise) ou RCC (« *Rear Contact Cell* » en langue anglaise), c'est-à-dire que les contacts électriques sont disposés sur la surface opposée à celle recevant le rayonnement solaire.

Une cellule photovoltaïque à contacts arrière comporte notamment :
- un substrat, réalisé dans un matériau semi-conducteur, et présentant une première surface, destinée à être orientée vers un rayonnement solaire, et une seconde surface opposée à la première surface ;
- des régions semi-conductrices dopées de type n et p, destinées à être en contact avec des électrodes, et s'étendant à la seconde surface.

### Etat de la technique antérieure

Il existe différents procédés pour former les régions semi-conductrices dopées de type n et p, mettant en œuvre des étapes d'implantation et/ou de diffusion de dopants. Nous allons nous concentrer sur des procédés mettant en œuvre la diffusion de dopants pour la formation des régions semi-conductrices dopées de type n et p.

Un premier procédé connu de l'état de la technique, notamment du document US 2011/0214719 (ci-après D1), comporte les étapes consistant à :
- former une couche de silicium polycristallin sur la seconde surface du substrat ;
- former une couche de verre borosilicate (BSG) sur une première partie de la couche de silicium polycristallin ;
- former une couche de verre phosphosilicate (PSG) sur la couche de BSG et sur une deuxième partie de la couche de silicium polycristallin, la deuxième partie de la couche de silicium polycristallin n'étant pas recouverte de BSG (cf. figure 2A de D1) ;
- graver les couches de BSG et de PSG de manière à espacer la couche de PSG, formée sur la deuxième partie de la couche de silicium polycristallin, et l'empilement BSG/PSG sur la première partie de la couche de silicium polycristallin (cf. figure 2B de D1) ;
- diffuser vers la couche de silicium polycristallin :
   - les atomes de phosphore depuis la couche de PSG formée sur la deuxième partie de la couche de silicium polycristallin, de manière à former les régions semi-conductrices dopées de type n, et
   - les atomes de bore depuis la couche de BSG de l'empilement BSG/PSG formé sur la première partie de la couche de silicium polycristallin, de manière à former les régions semi-conductrices dopées de type p ;
- retirer les couches de BSG et PSG par gravure (cf. figure 2E et §0034 de D1).

La passivation de la seconde surface du substrat est assurée par une couche de dioxyde de silicium formée entre la seconde surface du substrat et la couche de silicium polycristallin (D1, §0043).

Un tel premier procédé de l'état de la technique n'est pas entièrement satisfaisant dans la mesure où la formation d'une couche de silicium polycristallin sur le substrat introduit une complexité et un temps d'opération non négligeable si l'on compare à des régions semi-conductrices dopées de type n et p formées directement sous la seconde surface du substrat. En outre, le fait de former puis de retirer les couches de BSG et de PSG, impliquant par là-même la formation d'une couche de passivation dédiée, est également préjudiciable en termes de temps d'opération.

Un deuxième procédé connu de l'état de la technique, notamment du document WO 2012/074602 (ci-après D2), comporte les étapes consistant à :
- former une couche de silicium polycristallin sur la seconde surface du substrat ;
- former des couches de verre borosilicate (BSG) sur la couche de silicium polycristallin de sorte que la couche de silicium polycristallin présente des zones libres agencées pour séparer les couches de BSG entre elles (cf. figure 2C de D2) ;
- former une couche de P₂O₅ sur les couches de BSG et sur les zones libres de la couche de silicium polycristallin (cf. figure 2D de D2) ;
- diffuser vers la couche de silicium polycristallin :
   - les atomes de phosphore depuis la couche de P₂O₅, formée dans les zones libres de la couche de silicium polycristallin, de manière à former les régions semi-conductrices dopées de type n, et
   - les atomes de bore depuis les couches de BSG des empilements BSG/P₂O₅ de manière à former les régions semi-conductrices dopées de type p ;
- retirer les couches de BSG et de P₂O₅ (cf. figures 2F, 2H de D2, §0030, §0035).

La passivation de la seconde surface du substrat est assurée par une couche de dioxyde de silicium formée entre la seconde surface du substrat et la couche de silicium polycristallin (D2, §0025).

Un tel deuxième procédé de l'état de la technique n'est pas entièrement satisfaisant dans la mesure où la formation d'une couche de silicium polycristallin sur le substrat introduit une complexité et un temps d'opération non négligeable si l'on compare à des régions semi-conductrices dopées de type n et p formées directement sous la seconde surface du substrat. En outre, le fait de former puis de retirer les couches de BSG et de P₂O₅, impliquant par là-même la formation d'une couche de passivation dédiée, est également préjudiciable en termes de temps d'opération.

Un troisième procédé connu de l'état de la technique, notamment du document US 2007/0151598 (ci-après D3), comporte les étapes consistant à :
- former successivement, par impression sélective (e.g. jet d'encre), une première couche comportant du bore (un verre de spin SOG pour « *Spin-On Glass* » en langue anglaise) et une deuxième couche comportant du phosphore (un SOG) sur la seconde surface du substrat (cf. figure 2A de D3), les première et deuxième couches étant juxtaposées ;
- diffuser les atomes de bore et de phosphore depuis les première et deuxième couches sous la seconde surface du substrat (cf. figure 2B de D3).

La passivation de la seconde surface du substrat est assurée par une couche de dioxyde de silicium formée sur les première et deuxième couches (D3, §0030).

Un tel troisième procédé de l'état de la technique n'est pas entièrement satisfaisant dans la mesure où l'impression sélective introduit une certaine complexité, notamment dans le choix des première et deuxième couches, d'un solvant et d'un catalyseur (D3, §0029). En outre, il est nécessaire de former une couche de passivation dédiée, préjudiciable en termes de temps d'opération.

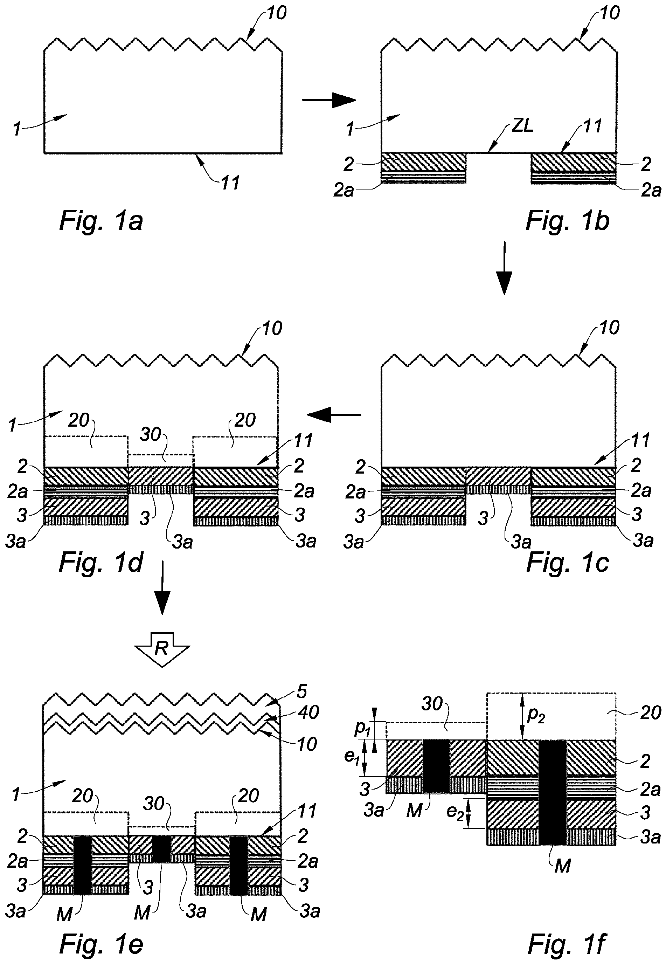

TANVIR NAUMAN BIN ET AL: "Codiffusion Sources and Barriers for the Assembly of Back-Contact Back-Junction Solar Cells", IEEE JOURNAL OF PHOTOVOLTAICS, IEEE, vol. 5, no. 6, 1 novembre 2015, pages 1813-1820, divulgue (figure 1) un procédé de fabrication de cellules photovoltaïques dites à contacts arrière, comportant les étapes: prévoir un substrat ("n-type Si"); former des premières couches diélectriques (PSG), sur la surface arrière de sorte que ladite surface présente des zones libres agencées pour séparer les premières couches diélectriques; former une deuxième couche diélectrique (BSG), sur les premières couches diélectriques (PSG) et sur les zones libres; faire co-diffuser les dopants de type n et les dopants de type p, depuis les couches PSG et depuis la couche BSG formée sur les zones libres, sous la surface arrière de manière à former des régions semi-conductrices dopées (n, p) destinées à être en contact avec des électrodes.

ENGELHARDT JOSH ET AL: "Passivating boron silicate glasses for co-diffused high-efficiency n-type silicon solar cell application", APPLIED PHYSICS LETTERS, vol. 107, no. 4, 27 juillet 2015 divulgue des couches diélectriques (SiOx:B ou SiOxNy:B) pour doper et passiver la face arrière des cellules photovoltaïques co-diffusées.

### Exposé de l'invention

L'invention vise à remédier en tout ou partie aux inconvénients précités. A cet effet, l'invention a pour objet un procédé de fabrication de cellules photovoltaïques dites à contacts arrière, selon la revendication 1.

La deuxième couche diélectrique, comportant des dopants de type p, est formée sur les premières couches diélectriques, comportant chacune des dopants de type n.

Cet ordre d'empilement est avantageux dans la mesure où l'inventeur a constaté de manière surprenante une adsorption privilégiée des dopants de type p, en particulier le bore, à la seconde surface du substrat. Ainsi, les dopants de type p, en particulier le bore, s'accumulent significativement plutôt à la seconde surface du substrat (dans les zones libres) que sur les premières couches diélectriques, lors de l'étape d).

Cette adsorption privilégiée permet donc de réduire le pouvoir dopant de la deuxième couche diélectrique formée sur les premières couches diélectriques, et par là-même autorise des épaisseurs relativement faibles (par exemple de l'ordre de 20 nm à 30 nm) des premières couches diélectriques, afin d'assurer le rôle de barrière de diffusion des dopants de type p depuis la deuxième couche diélectrique formée sur la première couche diélectrique correspondante.

Enfin, dans l'invention, les premières couches diélectriques et la deuxième couche diélectrique sont empilées et non juxtaposées, ce qui permet de les former aisément par exemple par une technique de dépôt chimique en phase vapeur, contrairement à une impression sélective de l'état de la technique plus complexe à mettre en œuvre.

### Définitions

- Par « substrat », on entend le support mécanique, autoporté, pour la fabrication de la cellule photovoltaïque.
- Par « couche diélectrique », on entend une couche réalisée dans un matériau diélectrique.
- Par « matériau diélectrique », on entend un matériau présentant une conductivité électrique à 300 K inférieure ou égale à 10⁻⁸ S.cm⁻¹.
- Par « dopants de type n », on entend des impuretés qui, introduites dans une matrice d'un matériau semi-conducteur à base de silicium, donnent un électron à la bande de conduction.
- Par « dopants de type p », on entend des impuretés qui, introduites dans une matrice d'un matériau semi-conducteur à base de silicium, acceptent un électron de la bande de conduction.
- Par « matériau semi-conducteur », on entend que le matériau présente une conductivité électrique à 300 K comprise entre 10⁻⁸ S.cm⁻¹ et 10³ S.cm⁻¹.
- Par « A formé sur B », on entend que l'entité A est formée sur l'entité B, mais pas nécessairement en contact avec l'entité B. En d'autres termes, l'expression « formé sur » n'exclut pas la présence d'élément(s) intercalaire(s) entre l'entité A et l'entité B.
- Par « passivation », on entend la neutralisation de défauts électriquement actifs à la surface du substrat semi-conducteur. En effet, la surface d'un matériau semi-conducteur présente une densité de défauts (e.g. liaisons pendantes, impuretés, discontinuités du cristal etc.) pouvant entraîner des pertes non négligeables liées à la recombinaison en surface des porteurs.
- Par « cristallin », on entend la forme multicristalline ou la forme monocristalline du silicium, excluant donc le silicium amorphe. Le dopage de type n du silicium permet d'améliorer le rendement de la cellule photovoltaïque.
- Par « à base de », on entend que le silicium est le matériau principal et majoritaire composant le substrat.

Le procédé selon l'invention peut comporter une ou plusieurs des caractéristiques suivantes.

Selon une caractéristique de l'invention, les premières couches diélectriques formées lors de l'étape b) présentent une épaisseur comprise entre 20 nm et 30 nm.

Ainsi, un avantage procuré par cette gamme d'épaisseur est d'être :
- suffisamment importante afin de former une barrière de diffusion pour les dopants de type p de la deuxième couche diélectrique formée sur les premières couches diélectriques.
- suffisamment faible afin de ne pas consommer ni trop de matière, ni trop de temps d'opération.

En outre, cette gamme d'épaisseur permet de minimiser les pertes liées aux recombinaisons des porteurs de charge dans le volume du substrat après l'étape d).

Selon l'invention, les premières couches diélectriques formées lors de l'étape b) sont à base d'un oxynitrure de silicium SiOₓN_{y} vérifiant 0≤x<y, de préférence hydrogéné.

Ainsi, un avantage procuré est d'obtenir une passivation satisfaisante de la seconde surface du substrat. En particulier, l'hydrogénation de l'oxynitrure de silicium améliore significativement la passivation. Lorsque x=0, l'oxynitrure de silicium est un nitrure de silicium. Il n'est donc pas nécessaire de supprimer les premières couches diélectriques afin de former ultérieurement des couches de passivation dédiées, contrairement à l'état de la technique. En d'autres termes, les premières couches diélectriques peuvent être conservées après l'étape d).

Par « à base de », on entend que l'oxynitrure de silicium est le matériau principal et majoritaire composant la couche diélectrique correspondante.

Selon une caractéristique de l'invention, la deuxième couche diélectrique formée lors de l'étape c) présente une épaisseur comprise entre 10 nm et 30 nm.

Ainsi, un avantage procuré par cette gamme d'épaisseur est d'améliorer la passivation de la seconde surface du substrat sans consommer ni trop de matière, ni trop de temps d'opération.

Selon l'invention, la deuxième couche diélectrique formée lors de l'étape c) est à base d'un oxynitrure de silicium SiOₓN_{y} vérifiant 0≤y<x, de préférence hydrogéné.

Ainsi, un avantage procuré est d'obtenir une passivation satisfaisante de la seconde surface du substrat. En particulier, l'hydrogénation de l'oxynitrure de silicium améliore significativement la passivation. Lorsque y=0, l'oxynitrure de silicium est un oxyde de silicium. Il n'est donc pas nécessaire de supprimer la deuxième couche diélectrique afin de former ultérieurement une couche de passivation dédiée, contrairement à l'état de la technique. En d'autres termes, la deuxième couche diélectrique est conservée après l'étape d).

Selon une caractéristique de l'invention, le procédé comporte une étape consistant à recouvrir les premières couches diélectriques d'une couche diélectrique additionnelle, avant l'étape c) ; la couche diélectrique additionnelle étant préférentiellement à base d'un oxynitrure de silicium SiOₓN_{y} vérifiant 0≤x<y, et plus préférentiellement hydrogéné.

Ainsi, un avantage procuré est d'améliorer la passivation de la seconde surface du substrat et d'empêcher l'exo-diffusion des dopants de type n hors du substrat en formant une barrière de diffusion.

Selon une caractéristique de l'invention, les premières couches diélectriques recouvertes de la couche diélectrique additionnelle forment un empilement présentant une épaisseur inférieure ou égale à 70 nm.

Ainsi, un avantage procuré est une faible consommation de matière et de temps d'opération.

Selon une caractéristique de l'invention, le procédé comporte une étape consistant à recouvrir la deuxième couche diélectrique d'une couche diélectrique additionnelle, avant l'étape d) ; la couche diélectrique additionnelle étant préférentiellement à base d'un oxynitrure de silicium SiOₓN_{y} vérifiant 0≤x<y, et plus préférentiellement hydrogéné.

Ainsi, un avantage procuré est d'améliorer la passivation de la seconde surface du substrat et d'empêcher l'exo-diffusion des dopants de type p hors du substrat en formant une barrière de diffusion.

Selon une caractéristique de l'invention, la deuxième couche diélectrique recouverte de la couche diélectrique additionnelle forme un empilement présentant une épaisseur inférieure ou égale à 100 nm.

Ainsi, un avantage procuré est une faible consommation de matière et de temps d'opération.

Selon une caractéristique de l'invention, les premières couches diélectriques formées lors de l'étape b) et la deuxième couche diélectrique formée lors de l'étape c) sont conservées après l'étape d).

Ainsi, un avantage procuré est un gain de temps d'opération puisqu'il n'est pas nécessaire retirer ces couches puis de former des couches de passivation dédiées.

Selon une caractéristique de l'invention, l'étape d) est exécutée de sorte que :
- les dopants de type n diffusent à une profondeur strictement inférieure à 2 µm à partir de la seconde surface, et
- les dopants de type p diffusent à une profondeur strictement inférieure à 1 µm à partir de la seconde surface.

Ainsi, de telles profondeurs permettent de former aisément des contacts électriques ultérieurement, par exemple par sérigraphie.

Selon une caractéristique de l'invention, la deuxième couche diélectrique présente, après l'étape d), une première épaisseur e₁ sur les zones libres et une seconde épaisseur e₂ sur les premières couches diélectriques vérifiant e₁ > e₂, préférentiellement e₁>1,5 e₂.

Ainsi, un avantage procuré par cette variation d'épaisseur est de former une signature structurelle de la cellule photovoltaïque pouvant être aisément détectée par ingénierie inverse. Cette variation d'épaisseur provient du fait que des dopants de type p de la deuxième couche diélectrique formée sur les premières couches diélectriques sont adsorbés sur les zones libres de la seconde surface du substrat.

Selon l'invention, l'étape d) est exécutée en appliquant un recuit thermique, de préférence sous une atmosphère oxydante.

Par « recuit thermique », on entend un traitement thermique comportant :
- une phase de montée graduelle en température (rampe de montée) jusqu'à atteindre une température dite température de recuit,
- une phase de maintien (plateau) à la température de recuit, pendant une durée dite durée de recuit,
- une phase de refroidissement.

Selon une caractéristique de l'invention, le procédé comporte une étape consistant à graver les zones libres de la seconde surface avant l'étape c) de manière à former des tranchées ; l'étape c) étant exécutée de sorte que la deuxième couche diélectrique est formée sur les premières couches diélectriques et dans les tranchées.

Ainsi, un avantage procuré est d'améliorer l'isolation électrique entre les régions semi-conductrices dopées en réduisant la superposition des dopants en termes de profil de concentration.

L'invention a également pour objet une cellule photovoltaïque dite à contact arrière, selon la revendication 11.

La cellule photovoltaïque selon l'invention peut comporter une ou plusieurs des caractéristiques suivantes.

Selon une caractéristique de l'invention, les premières couches diélectriques présentent une épaisseur comprise entre 20 nm et 30 nm.

Ainsi, un avantage procuré par cette gamme d'épaisseur est d'être :
- suffisamment importante afin de passiver le substrat de manière satisfaisante.
- suffisamment faible afin de ne pas consommer trop de matière.

Selon l'invention, les premières couches diélectriques sont à base d'un oxynitrure de silicium SiOₓN_{y} vérifiant 0≤x<y, de préférence hydrogéné.

Ainsi, un avantage procuré est d'obtenir une passivation satisfaisante de la seconde surface du substrat. En particulier, l'hydrogénation de l'oxynitrure de silicium améliore significativement la passivation. Lorsque x=0, l'oxynitrure de silicium est un nitrure de silicium.

Selon une caractéristique de l'invention, la deuxième couche diélectrique présente une première épaisseur e₁ sur les zones libres et une seconde épaisseur e₂ sur les premières couches diélectriques, vérifiant e₁>e₂, préférentiellement e₁>1,5 e₂, avec préférentiellement 10 nm ≤ e₂ ≤ 30 nm.

Ainsi, un avantage procuré par ces surépaisseurs locales est de former une signature structurelle de la cellule photovoltaïque pouvant être aisément détectée par ingénierie inverse.

Selon l'invention, la deuxième couche diélectrique est à base d'un oxynitrure de silicium SiOₓN_{y} vérifiant 0≤y<x, de préférence hydrogéné.

Ainsi, un avantage procuré est d'obtenir une passivation satisfaisante de la seconde surface du substrat. En particulier, l'hydrogénation de l'oxynitrure de silicium améliore significativement la passivation. Lorsque y=0, l'oxynitrure de silicium est un oxyde de silicium.

Selon une caractéristique de l'invention, la cellule photovoltaïque comporte une couche diélectrique additionnelle agencée pour recouvrir les premières couches diélectriques ; la couche diélectrique additionnelle étant préférentiellement à base d'un oxynitrure de silicium SiOₓN_{y} vérifiant 0≤x<y, et plus préférentiellement hydrogéné.

Ainsi, un avantage procuré est d'améliorer la passivation de la seconde surface du substrat.

Selon une caractéristique de l'invention, les premières couches diélectriques recouvertes de la couche diélectrique additionnelle forment un empilement présentant une épaisseur inférieure ou égale à 70 nm.

Ainsi, un avantage procuré est d'obtenir une excellente passivation de la seconde surface du substrat sans nécessiter trop de matière.

Selon une caractéristique de l'invention, la cellule photovoltaïque comporte une couche diélectrique additionnelle agencée pour recouvrir la deuxième couche diélectrique ; la couche diélectrique additionnelle étant préférentiellement à base d'un oxynitrure de silicium SiOₓN_{y} vérifiant 0≤x<y, et plus préférentiellement hydrogéné.

Ainsi, un avantage procuré est d'améliorer la passivation de la seconde surface du substrat.

Selon une caractéristique de l'invention, la deuxième couche diélectrique recouverte de la couche diélectrique additionnelle forme un empilement présentant une épaisseur inférieure ou égale à 100 nm.

Ainsi, un avantage procuré est d'obtenir une excellente passivation de la seconde surface du substrat sans nécessiter trop de matière.

### Brève description des dessins

D'autres caractéristiques et avantages apparaîtront dans l'exposé détaillé de différents modes de réalisation de l'invention, l'exposé étant assorti d'exemples et de référence aux dessins joints.
Figures la à le sont des vues schématiques en coupe illustrant différentes étapes d'un premier mode de mise en œuvre d'un procédé selon l'invention.
Figure 1f est une vue partielle, à l'échelle agrandie, de la figure le.
Figures 2a à 2f sont des vues schématiques en coupe illustrant différentes étapes d'un deuxième mode de mise en œuvre d'un procédé selon l'invention.

Les représentations des couches diélectriques 2, 2a, 3, 3a ont été volontairement simplifiées pour faciliter la compréhension de l'invention. Toutefois, ces représentations ne correspondent pas en toute rigueur à la réalité, dans la mesure où il n'existe pas de rupture aussi nette entre les différents empilements, en particulier pour un dépôt « pleine plaque ».

### Exposé détaillé des modes de réalisation

Les éléments identiques ou assurant la même fonction porteront les mêmes références pour les différents modes de réalisation, par souci de simplification.

Un objet de l'invention est un procédé de fabrication de cellules photovoltaïques dites à contacts arrière, comportant les étapes :
a) prévoir un substrat 1, réalisé dans un matériau semi-conducteur à base de silicium cristallin préférentiellement dopé de type n, et présentant :
   - une première surface 10, destinée à être orientée vers un rayonnement solaire R, et
   - une seconde surface 11 opposée à la première surface 10 ;
b) former des premières couches diélectriques 2, comportant chacune des dopants de type n, sur la seconde surface 11 de sorte que la seconde surface 11 présente des zones libres ZL agencées pour séparer les premières couches diélectriques 2 entre elles, les dopants de type n étant sélectionnés dans le groupe comportant P, As et Sb ;
c) former une deuxième couche diélectrique 3, comportant des dopants de type p, sur les premières couches diélectriques 2 et sur les zones libres ZL formées lors de l'étape b), les dopants de type p étant sélectionnés dans le groupe comportant B, Al, et Ga ;
d) diffuser les dopants de type n et les dopants de type p, respectivement depuis les premières couches diélectriques 2 et depuis la deuxième couche diélectrique 3 formée sur les zones libres ZL, sous la seconde surface 11 de manière à former des régions semi-conductrices dopées 20, 30 destinées à être en contact avec des électrodes M.

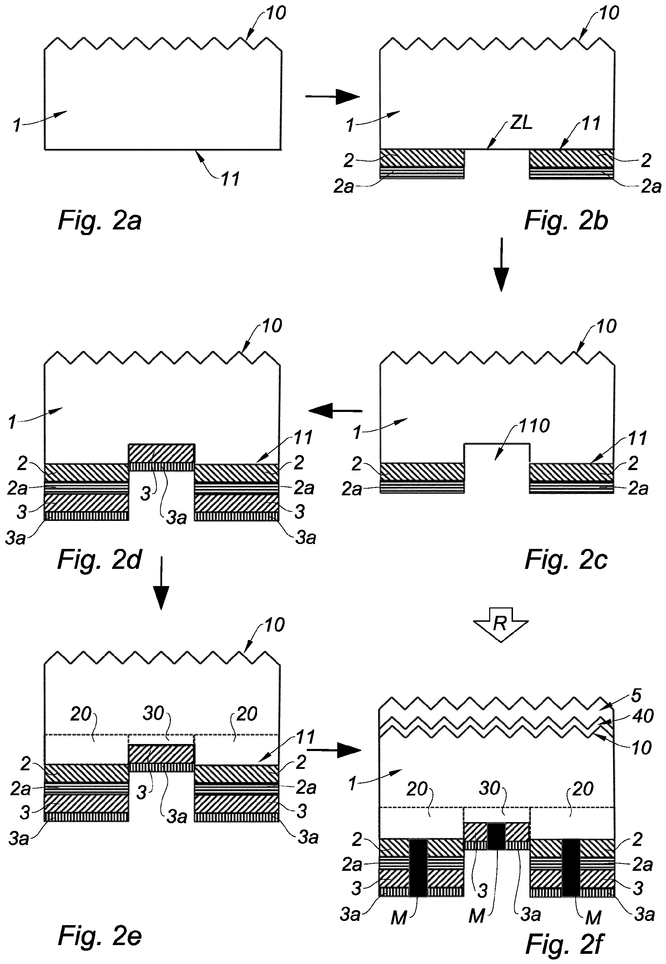

L'étape a) est illustrée aux figures la et 2a. L'étape b) est illustrée aux figures 1b et 2b. L'étape c) est illustrée aux figures 1c et 2d. L'étape d) est illustrée aux figures 1d et 2e.

### Substrat

Le matériau semi-conducteur dans lequel est réalisé le substrat 1 est à base de silicium cristallin, préférentiellement monocristallin. Le substrat 1 est avantageusement dopé de type n afin d'améliorer le rendement de la cellule photovoltaïque. La concentration des dopants de type n est avantageusement supérieure à 4,5x10⁴ at/cm³ de manière à obtenir une résistivité du substrat 1 inférieure à 10 Ohm.cm, avantageusement comprise entre 2 Ohm.cm et 7 Ohm.cm. Comme illustré aux figures la et 2a, la première surface 10 du substrat 1, destinée à être orientée vers un rayonnement solaire R, est avantageusement texturée afin de diminuer sa réflectivité. Ainsi, la première surface 10 du substrat 1 comporte préférentiellement des motifs en pyramide inversée agencés pour créer une rugosité de surface. La texturation de la première surface 10 du substrat 1 est préférentiellement exécutée par une attaque chimique à base d'hydroxyde de potassium KOH. La seconde surface 11 du substrat 1 peut être également texturée pour simplifier le procédé de texturation. A titre d'exemple non limitatif, le substrat 1 présente une épaisseur de l'ordre de 150 µm. Le procédé comporte avantageusement une étape consistant à nettoyer chimiquement les première et seconde surfaces 10, 11 du substrat 1 avant l'étape b).

### Premières couches diélectriques

Selon un mode de mise en œuvre, l'étape b) comporte les étapes :
b₁) former une première couche diélectrique sur la seconde surface 11 ;
b₂) graver la première couche diélectrique formée lors de l'étape b₁) de sorte que la seconde surface présente des zones libres ZL ; la première couche diélectrique gravée formant les premières couches diélectriques 2 séparées entre elles par les zones libres ZL. L'étape b₂) peut être exécutée avec un laser, et suivie éventuellement d'une gravure chimique.

Selon une alternative, les premières couches diélectriques 2, séparées entre elles par des zones libres, peuvent être formées directement par un dépôt chimique en phase vapeur, préférentiellement du type PECVD (pour *Plasma-Enhanced Chemical Vapor Deposition* en langue anglaise), à travers un masque par exemple.

Les premières couches diélectriques 2 formées lors de l'étape b) présentent avantageusement une épaisseur comprise entre 20 nm et 30 nm. Les premières couches diélectriques 2 formées lors de l'étape b) sont à base d'un oxynitrure de silicium SiOₓN_{y} vérifiant 0≤x<y, de préférence hydrogéné. Lorsque les premières couches diélectriques 2 sont à base d'un oxynitrure de silicium hydrogéné, l'étape b) est préférentiellement exécutée par un dépôt chimique en phase vapeur du type PECVD à partir de gaz réactifs comportant du silane SiH₄ et du NH₃. A titre d'exemple, lorsque les dopants de type n sont des atomes de phosphore, ceux-ci sont incorporés à l'oxynitrure de silicium hydrogéné par une injection de phosphine PH₃ avec les gaz réactifs. Lorsque les dopants de type n sont des atomes d'arsenic, ceux-ci peuvent être incorporés à l'oxynitrure de silicium hydrogéné par une injection d'arsine AsH₃ avec les gaz réactifs.

Comme illustré aux figures 1b et 2b, le procédé comporte avantageusement une étape consistant à recouvrir les premières couches diélectriques 2 d'une couche diélectrique additionnelle 2a, avant l'étape c). La couche diélectrique additionnelle 2a est préférentiellement à base d'un oxynitrure de silicium SiOₓN_{y} vérifiant 0≤x<y, et plus préférentiellement hydrogéné. Les premières couches diélectriques 2 recouvertes de la couche diélectrique additionnelle 2a forment un empilement présentant avantageusement une épaisseur inférieure ou égale à 70 nm.

Les premières couches diélectriques 2 formées lors de l'étape b), et le cas échéant la couche diélectrique additionnelle 2a, sont avantageusement conservées après l'étape d).

### Deuxième couche diélectrique

La deuxième couche diélectrique 3 formée lors de l'étape c) présente avantageusement une épaisseur comprise entre 10 nm et 30 nm. La deuxième couche diélectrique 3 formée lors de l'étape c) est à base d'un oxynitrure de silicium SiOₓN_{y} vérifiant 0≤y<x, de préférence hydrogéné. Lorsque la deuxième couche diélectrique 3 est à base d'un oxynitrure de silicium hydrogéné, l'étape c) est préférentiellement exécutée par un dépôt chimique en phase vapeur du type PECVD à partir de gaz réactifs comportant du silane SiH4 et du protoxyde d'azote N₂O. A titre d'exemple, lorsque les dopants de type p sont des atomes de bore, ceux-ci peuvent être incorporés à l'oxynitrure de silicium hydrogéné par une injection de diborane B₂H₆ avec les gaz réactifs.

Comme illustré à la figure 2c, le procédé comporte avantageusement une étape consistant à graver les zones libres ZL de la seconde surface 11 avant l'étape c) de manière à former des tranchées 110. Cette étape de gravure des zones libres ZL peut être exécutée par une gravure chimique sélective, telle qu'une attaque KOH. L'étape c) est alors exécutée de sorte que la deuxième couche diélectrique 3 est formée sur les premières couches diélectriques 2 et dans les tranchées 110. Les premières couches diélectriques 2 forment avantageusement un masque de gravure. Lorsque les premières couches diélectriques 2 sont recouvertes d'une couche diélectrique additionnelle 2a, l'étape c) est alors exécutée de sorte que la deuxième couche diélectrique 3 est formée sur les couches diélectriques additionnelles 2a.

Le procédé comporte avantageusement une étape consistant à recouvrir la deuxième couche diélectrique 3 d'une couche diélectrique additionnelle 3a, avant l'étape d). La couche diélectrique additionnelle 3a est préférentiellement à base d'un oxynitrure de silicium SiOₓN_{y} vérifiant 0≤x<y, et plus préférentiellement hydrogéné. La deuxième couche diélectrique 3 recouverte de la couche diélectrique additionnelle 3a forme un empilement présentant avantageusement une épaisseur inférieure ou égale à 100 nm.

La deuxième couche diélectrique 3 formée lors de l'étape c), et le cas échéant la couche diélectrique additionnelle 3a, sont avantageusement conservées après l'étape d).

La deuxième couche diélectrique 3 présente avantageusement, après l'étape d), une première épaisseur e₁ sur les zones libres et une seconde épaisseur e₂ sur les premières couches diélectriques vérifiant e₁ > e₂, préférentiellement e₁>1,5 e₂.

### Diffusion des dopants

Les dopants de type n sont sélectionnés dans le groupe comportant P, As, et Sb. Les dopants de type p sont sélectionnés dans le groupe comportant B, Al, et Ga.

L'étape d) est exécutée en appliquant un recuit thermique, de préférence sous une atmosphère oxydante. L'atmosphère oxydante comporte avantageusement du dioxygène et au moins un gaz neutre choisi parmi l'argon et l'azote. L'atmosphère oxydante est avantageusement constituée de dioxygène et d'au moins un gaz neutre choisi parmi l'argon et l'azote. L'atmosphère oxydante est avantageusement dépourvue d'agent dopant tel que la phosphine. Le recuit thermique appliqué lors de l'étape d) est un recuit thermique global au sens où il est appliqué à l'ensemble comportant le substrat 1, les premières couches diélectriques 2, la deuxième couche diélectrique 3 et le cas échéant les couches diélectriques additionnelles 2a, 3a. Il ne s'agit donc pas d'un recuit thermique localisé appliqué sur une partie dudit ensemble, par exemple à l'aide d'un laser. L'étape d) est préférentiellement exécutée dans un four.

L'étape d) est avantageusement exécutée de sorte que :
- les dopants de type n diffusent à une profondeur p₂ strictement inférieure à 2 µm à partir de la seconde surface 11, et
- les dopants de type p diffusent à une profondeur p₁ strictement inférieure à 1 µm à partir de la seconde surface 11.

Pour ce faire, d'une part, le recuit thermique appliqué lors de l'étape d) présente avantageusement :
- une valeur de température de recuit comprise entre 880°C et 980°C, préférentiellement comprise entre 900°C et 960°C, par exemple une température maximale comprise entre 880°C et 980°C et préférentiellement comprise entre 900°C et 960°C,
- une valeur de durée de recuit comprise entre 10 minutes et 1 heure, préférentiellement comprise entre 30 minutes et 1 heure.

Pour ce faire, d'autre part, les dopants de type p, tels que des atomes de bore, présentent préférentiellement une proportion atomique dans la deuxième couche diélectrique 3 comprise entre 10% et 50%, plus préférentiellement comprise entre 10% et 30%, avant l'étape d). Les dopants de type n, tels que des atomes de phosphore, présentent préférentiellement une proportion atomique dans les premières couches diélectriques 2 comprise entre 1% et 10% avant l'étape d).

Après l'étape d), les régions semi-conductrices dopées 20 de type p présentent préférentiellement, à la seconde surface 11, une concentration atomique surfacique supérieure à 10¹⁹ at./cm³, plus préférentiellement comprise entre 10¹⁹ at./cm³ et 3x10²⁰ at./cm³, afin de former une zone de contact électrique de bonne qualité.

Après l'étape d), les régions semi-conductrices dopées 30 de type n présentent préférentiellement, à la seconde surface 11, une concentration atomique surfacique supérieure à 10²⁰ at./cm³, plus préférentiellement comprise entre 10²⁰ at./cm³ et 10²¹ at./cm³, afin de former une zone de contact électrique de bonne qualité.

### Champ de surface avant

Comme illustré aux figures le et 2f, le procédé comporte avantageusement une étape consistant à former une région semi-conductrice 40 à la première surface 10 du substrat 1. La région semi-conductrice 40 est avantageusement fortement dopée (concentration des dopants supérieure à 5x10¹⁸ at/cm³) du même type de dopage que le substrat 1 de manière à former un champ de surface avant (FSF pour «*Front Surface Field*» en langue anglaise). Une telle région semi-conductrice 40 permet de réduire les recombinaisons des porteurs à la première surface 10 du substrat 1.

### Passivation de la première surface du substrat

Comme illustré aux figures le et 2f, le procédé comporte avantageusement une étape consistant à former une couche de passivation 5 sur la région semi-conductrice 40, la couche de passivation 5 pouvant également avoir une fonction antireflet par une épaisseur ajustée.

### Formation des électrodes

Comme illustré aux figures le, 1f et 2f, le procédé comporte avantageusement une étape e) consistant à mettre en contact les régions semi-conductrices dopées 20, 30 avec une électrode M. L'étape e) comporte avantageusement une étape de métallisation, de préférence exécutée par sérigraphie. Chaque électrode M est préférentiellement réalisée en argent et/ou aluminium.

De manière avantageuse, les premières couches diélectriques 2 et la deuxième couche diélectrique 3 sont conservées au moins jusqu'à la formation des électrodes M et éventuellement après le dépôt des électrodes M, de préférence durant toute la vie de la cellule photovoltaïque. Le procédé de fabrication peut donc être dépourvu d'une étape de retrait des premières couches diélectriques 2 et de la deuxième couche diélectrique 3.

Il est également avantageux de prévoir que le procédé de fabrication soit dépourvu d'une étape de passivation de la face arrière.

Dans un mode de réalisation avantageux, la deuxième couche diélectrique 3 en l'oxynitrure de silicium SiOₓN_{y} et qui vérifie 0≤y<x est réalisée de sorte que 0≤*y*≤0,10 de préférence de sorte que 0≤*y*≤0,05. Il est également avantageux d'avoir *x*≥0,50 de préférence 0,50≤*x*≤0,66 pour améliorer la passivation de la surface. L'oxynitrure de silicium est de préférence hydrogéné afin d'améliorer la qualité de la passivation. Lorsque y=0, l'oxynitrure de silicium est un oxyde de silicium. Les valeurs x et y représentant des teneurs atomiques.

Dans un mode de réalisation avantageux, les premières couches diélectriques 2 à base d'un oxynitrure de silicium SiOₓN_{y} vérifiant 0≤x<y sont réalisées dans un matériau qui permet de passiver la surface du substrat. L'oxynitrure de silicium est de préférence hydrogéné afin d'améliorer la qualité de la passivation. Lorsque x=0, l'oxynitrure de silicium est un nitrure de silicium.

Selon une forme d'exécution, l'oxynitrure de silicium SiOₓN_{y} des premières couches diélectriques 2 vérifie 0≤*x*≤0,05. Selon une forme d'exécution, l'oxynitrure de silicium SiOₓN_{y} des premières couches diélectriques 2 vérifie 0,30≤*y*≤0,55. La passivation est améliorée et cela permet également d'améliorer les caractéristiques anti-reflet.

L'invention ne se limite pas aux modes de réalisation exposés, l'étendue de la protection couvrant la portée des revendications.

## Revendications

1. Procédé de fabrication de cellules photovoltaïques dites à contacts arrière, comportant les étapes :
a) prévoir un substrat (1), réalisé dans un matériau semi-conducteur à base de silicium cristallin préférentiellement dopé de type n, et présentant :
- une première surface (10), destinée à être orientée vers un rayonnement solaire (R), et
- une seconde surface (11) opposée à la première surface (10) ;
b) former des premières couches diélectriques (2) à base d'un oxynitrure ou nitrure de silicium SiOₓN_{y} vérifiant 0≤x<y de préférence hydrogéné, les premières couches diélectriques (2) comportant chacune des dopants de type n, sur la seconde surface (11) de sorte que la seconde surface (11) présente des zones libres (ZL) agencées pour séparer les premières couches diélectriques (2) entre elles, les dopants de type n étant sélectionnés dans le groupe comportant P, As, et Sb ;
c) former une deuxième couche diélectrique (3) à base d'un oxynitrure ou oxyde de silicium SiOₓN_{y} vérifiant 0≤y<x de préférence hydrogéné, la deuxième couche diélectrique (3) comportant des dopants de type p, sur les premières couches diélectriques (2) et sur les zones libres (ZL) formées lors de l'étape b), les dopants de type p étant sélectionnés dans le groupe comportant B, Al, et Ga ;
d) appliquer un recuit thermique, de préférence sous une atmosphère oxydante, pour faire diffuser les dopants de type n et les dopants de type p, respectivement depuis les premières couches diélectriques (2) et depuis la deuxième couche diélectrique (3) formée sur les zones libres (ZL), sous la seconde surface (11) de manière à former des régions semi-conductrices dopées (20, 30) destinées à être en contact avec des électrodes (M).

2. Procédé selon la revendication 1, dans lequel les premières couches diélectriques (2) formées lors de l'étape b) présentent une épaisseur comprise entre 20 nm et 30 nm et/ou la deuxième couche diélectrique (3) formée lors de l'étape c) présente une épaisseur comprise entre 10 nm et 30 nm.

3. Procédé selon l'une des revendications précédentes, comportant une étape consistant à recouvrir les premières couches diélectriques (2) d'une couche diélectrique additionnelle (2a), avant l'étape c) ; la couche diélectrique additionnelle (2a) étant préférentiellement à base d'un oxynitrure ou nitrure de silicium SiOₓN_{y} vérifiant 0≤x<y, et plus préférentiellement hydrogéné, les premières couches diélectriques (2) recouvertes de la couche diélectrique additionnelle (2a) formant un empilement présentant une épaisseur préférentiellement inférieure ou égale à 70 nm.

4. Procédé selon l'une des revendications précédentes, comportant une étape consistant à recouvrir la deuxième couche diélectrique (3) d'une couche diélectrique additionnelle (3a), avant l'étape d) ; la couche diélectrique additionnelle (3a) étant préférentiellement à base d'un oxynitrure ou nitrure de silicium SiOₓN_{y} vérifiant 0≤x<y, et plus préférentiellement hydrogéné, la deuxième couche diélectrique (3) recouverte de la couche diélectrique additionnelle (3a) formant un empilement présentant une épaisseur préférentiellement inférieure ou égale à 100 nm.

5. Procédé selon l'une des revendications précédentes, dans lequel les premières couches diélectriques (2) formées lors de l'étape b) et la deuxième couche diélectrique (3) formée lors de l'étape c) sont conservées après l'étape d).

6. Procédé selon l'une des revendications précédentes, dans lequel l'étape d) est exécutée de sorte que :
- les dopants de type n diffusent à une profondeur (p₂) strictement inférieure à 2 µm à partir de la seconde surface (11), et
- les dopants de type p diffusent à une profondeur (p₁) strictement inférieure à 1 µm à partir de la seconde surface (11).

7. Procédé selon l'une des revendications précédentes, dans lequel la deuxième couche diélectrique (3) présente, après l'étape d), une première épaisseur e₁ sur les zones libres (ZL) et une seconde épaisseur e₂ sur les premières couches diélectriques (2) vérifiant e₁ > e₂, préférentiellement e₁>1,5 e₂.

8. Procédé selon l'une des revendications précédentes, comportant une étape consistant à graver les zones libres (ZL) de la seconde surface (11) avant l'étape c) de manière à former des tranchées (110) ; l'étape c) étant exécutée de sorte que la deuxième couche diélectrique (3) est formée sur les premières couches diélectriques (2) et dans les tranchées (110).

9. Procédé selon l'une des revendications précédentes, dans lequel l'atmosphère oxydante comporte du dioxygène et au moins un gaz neutre choisi parmi l'argon et l'azote et l'atmosphère oxydante est avantageusement dépourvue de phosphine.

10. Procédé selon l'une des revendications précédentes, dans lequel le recuit thermique comporte une phase de montée en température jusqu'à une valeur de température comprise entre 880°C et 980°C, préférentiellement comprise entre 900°C et 960°C, avec une durée de recuit thermique comprise entre 10 minutes et 1 heure.

11. Cellule photovoltaïque dite à contact arrière, comportant :
- un substrat (1), réalisé dans un matériau semi-conducteur à base de silicium cristallin préférentiellement dopé de type n, et présentant une première surface (10), destinée à être orientée vers un rayonnement solaire (R), et une seconde surface (11) opposée à la première surface (10) ;
- des premières couches diélectriques (2) à base d'un oxynitrure ou nitrure de silicium SiOₓN_{y} vérifiant 0≤x<y préférentiellement hydrogéné, les premières couches diélectriques (2) comportant chacune des résidus de dopants de type n, formées sur la seconde surface (11), les dopants de type n étant sélectionnés dans le groupe comportant P, As, et Sb ; la seconde surface (11) présentant des zones libres (ZL) agencées pour séparer les premières couches diélectriques (2) entre elles ;
- une deuxième couche diélectrique (3) à base d'un oxynitrure ou oxyde de silicium SiOₓN_{y} vérifiant 0≤y<x préférentiellement hydrogéné, la deuxième couche diélectrique (3) comportant des résidus de dopants de type p, formée sur les premières couches diélectriques (2) et sur les zones libres (ZL), les dopants de type p étant sélectionnés dans le groupe comportant B, Al et Ga;
- des régions semi-conductrices dopées (20, 30) de type n et p, destinées à être en contact avec des électrodes (M), et s'étendant sous la seconde surface (11).

12. Cellule photovoltaïque selon la revendication précédente, dans laquelle les premières couches diélectriques (2) présentent une épaisseur comprise entre 20 nm et 30 nm et/ou la deuxième couche diélectrique (3) présente une première épaisseur e₁ sur les zones libres (ZL) et une seconde épaisseur e₂ sur les premières couches diélectriques (2), vérifiant e₁>e₂, préférentiellement e₁>1,5 e₂, avec préférentiellement 10 nm ≤ e₂ ≤ 30 nm.

13. Cellule photovoltaïque selon l'une des revendications 11 et 12, comportant une couche diélectrique additionnelle (2a) agencée pour recouvrir les premières couches diélectriques (2) ; la couche diélectrique additionnelle (2a) étant préférentiellement à base d'un oxynitrure ou nitrure de silicium SiOₓN_{y} vérifiant 0≤x<y, et plus préférentiellement hydrogéné, les premières couches diélectriques (2) recouvertes de la couche diélectrique additionnelle (2a) formant un empilement présentant une épaisseur préférentiellement inférieure ou égale à 70 nm

14. Cellule photovoltaïque selon l'une des revendications 11 à 13, comportant une couche diélectrique additionnelle (3a) agencée pour recouvrir la deuxième couche diélectrique (3) ; la couche diélectrique additionnelle (3a) étant préférentiellement à base d'un oxynitrure ou nitrure de silicium SiOₓN_{y} vérifiant 0≤x<y, et plus préférentiellement hydrogéné, la deuxième couche diélectrique (3) recouverte de la couche diélectrique additionnelle (3a) formant un empilement présentant une épaisseur préférentiellement inférieure ou égale à 100 nm.

## Patentansprüche

1. Verfahren zur Herstellung von Rückkontakt-Photovoltaikzellen, umfassend die folgenden Schritte:
a) Bereitstellen eines Substrats (1), das aus einem Halbleitermaterial auf der Basis von kristallinem Silicium, bevorzugt n-dotiert, ausgeführt ist und aufweist:
- eine erste Fläche (10), die dazu bestimmt ist, zu einer Sonnenstrahlung (R) hin ausgerichtet zu sein, und
- eine zweite Fläche (11), die zur ersten Fläche (10) entgegengesetzt ist;
b) Bilden von ersten dielektrischen Schichten (2) auf der Basis eines Siliciumoxinitrids oder -nitrids SiOₓN_{y} mit 0≤x<y, bevorzugt hydriert, wobei die ersten dielektrischen Schichten (2) jeweils n-Dotierungsstoffe umfassen, auf der zweiten Fläche (11) derart, dass die zweite Fläche (11) freie Bereiche (ZL) aufweist, die so gestaltet sind, dass sie die ersten dielektrischen Schichten (2) voneinander trennen, wobei die n-Dotierungsstoffe aus der Gruppe gewählt sind, die P, As und Sb umfasst;
c) Bilden einer zweiten dielektrischen Schicht (3) auf der Basis eines Siliciumoxinitrids oder -oxids SiOₓN_{y} mit 0≤y<x, bevorzugt hydriert, wobei die zweite dielektrische Schicht (3) p-Dotierungsstoffe umfasst, auf den im Schritt b) gebildeten ersten dielektrischen Schichten (2) und freien Bereichen (ZL), wobei die p-Dotierungsstoffe aus der Gruppe gewählt sind, die B, Al und Ga umfasst;
d) Anwenden einer thermischen Behandlung, bevorzugt unter einer oxidierenden Atmosphäre, um die n-Dotierungsstoffe und die p-Dotierungsstoffe jeweils von den ersten dielektrischen Schichten (2) aus und von der zweiten dielektrischen Schicht (3) aus, die auf den freien Bereichen (ZL) gebildet ist, unter die zweite Fläche (11) diffundieren zu lassen, so dass dotierte Halbleiterregionen (20, 30) gebildet werden, die dazu bestimmt sind, mit Elektroden (M) in Kontakt zu sein.

2. Verfahren nach Anspruch 1, bei dem die im Schritt b) gebildeten ersten dielektrischen Schichten (2) eine Dicke zwischen 20 nm und 30 nm aufweisen und/oder die im Schritt c) gebildete zweite dielektrische Schicht (3) eine Dicke zwischen 10 nm und 30 nm aufweist.

3. Verfahren nach einem der vorhergehenden Ansprüche, umfassend einen Schritt, der darin besteht, die ersten dielektrischen Schichten (2) vor dem Schritt c) mit einer zusätzlichen dielektrischen Schicht (2a) zu überziehen, wobei die zusätzliche dielektrische Schicht (2a) bevorzugt auf der Basis eines Siliciumoxinitrids oder -nitrids SiOₓN_{y} mit 0≤x<y und noch bevorzugter hydriert ist, wobei die mit der zusätzlichen dielektrischen Schicht (2a) überzogenen ersten dielektrischen Schichten (2) ein Schichtsystem bilden, das eine Dicke von bevorzugt 70 nm oder weniger aufweist.

4. Verfahren nach einem der vorhergehenden Ansprüche, umfassend einen Schritt, der darin besteht, die zweite dielektrische Schicht (3) vor dem Schritt d) mit einer zusätzlichen dielektrischen Schicht (3a) zu überziehen, wobei die zusätzliche dielektrische Schicht (3a) bevorzugt auf der Basis eines Siliciumoxinitrids oder -nitrids SiOₓN_{y} mit 0≤x<y und noch bevorzugter hydriert ist, wobei die mit der zusätzlichen dielektrischen Schicht (3a) überzogene zweite dielektrische Schicht (3) ein Schichtsystem bildet, das eine Dicke von bevorzugt 100 nm oder weniger aufweist.

5. Verfahren nach einem der vorhergehenden Ansprüche, bei dem die im Schritt b) gebildeten ersten dielektrischen Schichten (2) und die im Schritt c) gebildete zweite dielektrische Schicht (3) nach dem Schritt d) beibehalten werden.

6. Verfahren nach einem der vorhergehenden Ansprüche, bei dem der Schritt d) derart ausgeführt wird, dass:
- die n-Dotierungsstoffe von der zweiten Fläche (11) aus in eine Tiefe (p₂) von weniger als 2 µm diffundieren und
- die p-Dotierungsstoffe von der zweiten Fläche (11) aus in eine Tiefe (p₁) von weniger als 1 µm diffundieren.

7. Verfahren nach einem der vorhergehenden Ansprüche, bei dem die zweite dielektrische Schicht (3) nach dem Schritt d) eine erste Dicke e₁ auf den freien Bereichen (ZL) und eine zweite Dicke e₂ auf den ersten dielektrischen Schichten (2) aufweist mit e₁ > e₂, bevorzugt e₁>1,5 e₂.

8. Verfahren nach einem der vorhergehenden Ansprüche, umfassend einen Schritt, der darin besteht, die freien Bereiche (ZL) der zweiten Fläche (11) vor dem Schritt c) derart zu ätzen, dass Gräben (110) gebildet werden, wobei der Schritt c) so ausgeführt wird, dass die zweite dielektrische Schicht (3) auf den ersten dielektrischen Schichten (2) und in den Gräben (110) gebildet wird.

9. Verfahren nach einem der vorhergehenden Ansprüche, bei dem die oxidierende Atmosphäre Disauerstoff und mindestens ein neutrales Gas, das unter Argon und Stickstoff gewählt ist, umfasst und die oxidierende Atmosphäre vorteilhafterweise phosphinfrei ist.

10. Verfahren nach einem der vorhergehenden Ansprüche, bei dem die thermische Behandlung eine Temperaturanstiegsphase bis auf einen Wert zwischen 880°C und 980°C, bevorzugt zwischen 900°C und 960°C umfasst, mit einer Dauer der thermischen Behandlung zwischen 10 Minuten und 1 Stunde.

11. Rückkontakt-Photovoltaikzelle, umfassend:
- ein Substrat (1), das aus einem Halbleitermaterial auf der Basis von kristallinem Silicium, bevorzugt n-dotiert, ausgeführt ist und eine erste Fläche (10), die dazu bestimmt ist, zu einer Sonnenstrahlung (R) hin ausgerichtet zu sein, und eine zweite Fläche (11), die zur ersten Fläche (10) entgegengesetzt ist, aufweist;
- erste dielektrische Schichten (2) auf der Basis eines Siliciumoxinitrids oder -nitrids SiOₓN_{y} mit 0≤x<y, bevorzugt hydriert, wobei die ersten dielektrischen Schichten (2) jeweils Reste von n-Dotierungsstoffen umfassen und auf der zweiten Fläche (11) gebildet sind, wobei die n-Dotierungsstoffe aus der Gruppe gewählt sind, die P, As und Sb umfasst, wobei die zweite Fläche (11) freie Bereiche (ZL) aufweist, die so gestaltet sind, dass sie die ersten dielektrischen Schichten (2) voneinander trennen;
- eine zweite dielektrische Schicht (3) auf der Basis eines Siliciumoxinitrids oder - oxids SiOₓN_{y} mit 0≤y<x, bevorzugt hydriert, wobei die zweite dielektrische Schicht (3) Reste von p-Dotierungsstoffen umfasst und auf den ersten dielektrischen Schichten (2) und auf den freien Bereichen (ZL) gebildet ist, wobei die p-Dotierungsstoffe aus der Gruppe gewählt sind, die B, Al und Ga umfasst;
- n- und p-dotierte Halbleiterregionen (20, 30), die dazu bestimmt sind, mit Elektroden (M) in Kontakt zu sein, und sich unter der zweiten Fläche (11) erstrecken.

12. Photovoltaikzelle nach dem vorhergehenden Anspruch, bei der die ersten dielektrischen Schichten (2) eine Dicke zwischen 20 nm und 30 nm aufweisen und/oder die zweite dielektrische Schicht (3) eine erste Dicke e₁ auf den freien Bereichen (ZL) und eine zweite Dicke e₂ auf den ersten dielektrischen Schichten (2) aufweist mit e₁>e₂, bevorzugt e₁>1,5 e₂, mit bevorzugt 10 nm ≤ e₂ ≤ 30 nm.

13. Photovoltaikzelle nach einem der Ansprüche 11 und 12, umfassend eine zusätzliche dielektrische Schicht (2a), die so gestaltet ist, dass sie die ersten dielektrischen Schichten (2) überzieht, wobei die zusätzliche dielektrische Schicht (2a) bevorzugt auf der Basis eines Siliciumoxinitrids oder -nitrids SiOₓN_{y} mit 0≤x<y und noch bevorzugter hydriert ist, wobei die mit der zusätzlichen dielektrischen Schicht (2a) überzogenen ersten dielektrischen Schichten (2) ein Schichtsystem bilden, das eine Dicke von bevorzugt 70 nm oder weniger aufweist.

14. Photovoltaikzelle nach einem der Ansprüche 11 bis 13, umfassend eine zusätzliche dielektrische Schicht (3a), die so gestaltet ist, dass sie die zweite dielektrische Schicht (3) überzieht, wobei die zusätzliche dielektrische Schicht (3a) bevorzugt auf der Basis eines Siliciumoxinitrids oder -nitrids SiOₓN_{y} mit 0≤x<y und noch bevorzugter hydriert ist, wobei die mit der zusätzlichen dielektrischen Schicht (3a) überzogene zweite dielektrische Schicht (3) ein Schichtsystem bildet, das eine Dicke von bevorzugt 100 nm oder weniger aufweist.

## Claims

1. Process for fabricating back-contact photovoltaic cells, comprising the steps of:
a) providing a substrate (1) made of a semiconductor based on crystalline silicon that is preferably doped n-type, and having:
- a first surface (10), intended to be oriented toward solar radiation (R), and
- a second surface (11) opposite to the first surface (10);
b) forming first dielectric layers (2) based on preferably hydrogenated silicon oxynitride or nitride SiOₓN_{y}, respecting 0≤x<y, the first dielectric layers (2) each comprising n-type dopants, on the second surface (11) so that the second surface (11) presents free zones (ZL) arranged to separate the first dielectric layers (2) from one another, the n-type dopants being selected from the group comprising P, As and Sb;
c) forming a second dielectric layer (3) based on preferably hydrogenated silicon oxynitride or oxide SiOₓN_{y}, respecting 0≤y<x, the second dielectric layer (3) comprising p-type dopants, on the first dielectric layers (2) and on the free zones (ZL) formed in step b), the p-type dopants being selected from the group comprising B, Al and Ga;
d) applying a thermal anneal, preferably under an oxidizing atmosphere, in order to make the n-type dopants and the p-type dopants diffuse from the first dielectric layers (2) and from the second dielectric layer (3) formed on the free zones (ZL), respectively, under the second surface (11) so as to form doped semiconductor regions (20, 30) intended to make contact with electrodes (M).

2. Process according to Claim 1, wherein the first dielectric layers (2) formed in step b) have a thickness comprised between 20 nm and 30 nm and/or the second dielectric layer (3) formed in step c) has a thickness comprised between 10 nm and 30 nm.

3. Process according to one of the preceding claims, comprising a step consisting in covering the first dielectric layers (2) with an additional dielectric layer (2a), before step c), the additional dielectric layer (2a) preferably being based on preferably hydrogenated silicon oxynitride or nitride SiOₓN_{y}, respecting 0≤x<y, the first dielectric layers (2) covered with the additional dielectric layer (2a) forming a stack having a thickness that is preferably smaller than or equal to 70 nm.

4. Process according to one of the preceding claims, comprising a step consisting in covering the second dielectric layer (3) with an additional dielectric layer (3a), before step d), the additional dielectric layer (3a) preferably being based on preferably hydrogenated silicon oxynitride or nitride SiOₓN_{y}, respecting 0≤x<y, the second dielectric layer (3) covered with the additional dielectric layer (3a) forming a stack having a thickness that is preferably smaller than or equal to 100 nm.

5. Process according to one of the preceding claims, wherein the first dielectric layers (2) formed in step b) and the second dielectric layer (3) formed in step c) are preserved after step d).

6. Process according to one of the preceding claims, wherein step d) is executed so that:
- the n-type dopants diffuse to a depth (p₂) strictly smaller than 2 µm from the second surface (11), and
- the p-type dopants diffuse to a depth (p₁) strictly smaller than 1 µm from the second surface (11).

7. Process according to one of the preceding claims, wherein the second dielectric layer (3) has, after step d), a first thickness e₁ on the free zones (ZL) and a second thickness e₂ on the first dielectric layers (2), respecting e₁ > e₂, and preferably e₁ > 1.5 e2.

8. Process according to one of the preceding claims, comprising a step consisting in etching the free zones (ZL) of the second surface (11) before step c) so as to form trenches (110), step c) being executed so that the second dielectric layer (3) is formed on the first dielectric layers (2) and in the trenches (110).

9. Process according to one of the preceding claims, wherein the oxidizing atmosphere comprises dioxygen and at least one inert gas chosen from argon and nitrogen and the oxidizing atmosphere is advantageously devoid of phosphine.

10. Process according to one of the preceding claims, wherein the thermal anneal comprises a temperature ramp to a temperature value comprised between 880°C and 980°C, and preferably comprised between 900°C and 960°C, with a thermal-anneal length comprised between 10 minutes and 1 hour.

11. Back-contact photovoltaic cell, comprising:
- a substrate (1) made of a semiconductor based on crystalline silicon that is preferably doped n-type, and having a first surface (10), intended to be oriented toward solar radiation (R), and a second surface (11) opposite to the first surface (10);
- first dielectric layers (2) based on preferably hydrogenated silicon oxynitride or nitride SiOₓN_{y}, respecting 0≤x<y, the first dielectric layers (2) each comprising residues of n-type dopants, said layers being formed on the second surface (11), the n-type dopants being selected from the group comprising P, As and Sb; the second surface (11) presenting free zones (ZL) arranged to separate the first dielectric layers (2) from one another;
- a second dielectric layer (3) based on preferably hydrogenated silicon oxynitride or oxide SiOₓN_{y}, respecting 0≤y<x, the second dielectric layer (3) comprising residues of p-type dopants, said layer being formed on the first dielectric layers (2) and on the free zones (ZL), the p-type dopants being selected from the group comprising B, Al and Ga;
- semiconductor regions (20, 30) doped n- and p-type, said regions being intended to make contact with electrodes (M), and lying under the second surface (11).

12. Photovoltaic cell according to the preceding claim, wherein the first dielectric layers (2) have a thickness comprised between 20 nm and 30 nm and/or the second dielectric layer (3) has a first thickness e₁ on the free zones (ZL) and a second thickness e₂ on the first dielectric layers (2), respecting e₁ > e₂, and preferably e₁ > 1.5 e₂, with preferably 10 nm ≤ e₂ ≤ 30 nm.

13. Photovoltaic cell according to one of Claims 11 and 12, comprising an additional dielectric layer (2a) arranged to cover the first dielectric layers (2), the additional dielectric layer (2a) preferably being based on preferably hydrogenated silicon oxynitride or nitride SiOₓN_{y}, respecting 0≤x<y, the first dielectric layers (2) covered with the additional dielectric layer (2a) forming a stack having a thickness that is preferably smaller than or equal to 70 nm.

14. Photovoltaic cell according to one of Claims 11 to 13, comprising an additional dielectric layer (3a) arranged to cover the second dielectric layer (3), the additional dielectric layer (3a) preferably being based on preferably hydrogenated silicon oxynitride or nitride SiOₓN_{y}, respecting 0≤x<y, the second dielectric layer (3) covered with the additional dielectric layer (3a) forming a stack having a thickness that is preferably smaller than or equal to 100 nm.
